# EUROPEAN PATENT APPLICATION

(11) **EP 4 696 500 A1**
(43) Date of publication of application: **18.02.2026**
(21) Application number: 25194632.3
(22) Date of filing: 07.08.2025
(51) Int. Cl.: B32B 15/01, C22C 28/00, C22C 30/00, C22C 30/04, C25D 3/54, C25D 7/06, H05K 7/20, B32B 7/027, C25D 7/00

(54) **MULTILAYER COMPOSITE THERMAL CONDUCTIVE SHEET AND PREPARATION METHOD THEREFOR AND APPLICATION THEREOF**

(30) Priority: 15.08.2024 CN 202411121351
(71) Applicant: Shenzhen HFC Co., Ltd., Guangdong 518103 (CN)
(72) Inventor: Zhang, Jianan, Guangdong, 518103 (CN); Cao, Yong, Guangdong, 518103 (CN); Liu, Jinming, Guandong, 518103 (CN); Sun, Aixiang, Guandong, 518103 (CN)
(74) Representative: Nordic Patent Service A/S

(57) **Abstract**

The present disclosure relates to a multilayer composite thermal conductive sheet and its preparation method and application, belonging to the technical field of thermal conductive materials. The sheet includes a metal foil, two transition layers on opposite side surfaces of the metal foil, and two low-temperature alloy layers, with a melting point of 30-300°C, respectively on surfaces of the transition layers away from the metal foil. The metal foil consists of at least one of silver, copper, zinc, and platinum. The transition layer is made of either indium or tin, with a thickness of 5-13 µm. Compounded with a specific metal foil, a transition layer and a low-temperature alloy layer, the sheet has excellent thermal conductivity, with a thermal conductivity greater than 25 W/m·K, and a thermal resistance of less than 0.025 cm²·K/W, while solving the problems such as leakage, sagging, and void formation of liquid metal.

## Description

### TECHNICAL FIELD

The present disclosure relates to the technical field of thermal conductive materials, and particularly relates to a multilayer composite thermal conductive sheet, and a preparation method therefor and an application thereof.

### BACKGROUND ART

As a novel type of thermal interface material, liquid metal has been utilized to solve the heat dissipation problem of components due to its low thermal resistance and high thermal conductivity. However, owing to its fluidity, leakage of liquid metal during application remains a common concern. Although surrounding the electronic components (such as a chip) with a ring foam for barrier can reduce the risk of short circuits caused by liquid metal overflow to some extent, this method not only increases additional costs and occupies considerable space, but also fails to completely block the overflow of liquid metal due to the gap between the foam and the chip surface. Such overflow may still result in problems such as void formation and sagging after phase transition melting of the liquid metal, thereby significantly compromising the thermal performance of the product.

Prior studies have attempted to address the above issue of liquid metal leakage to some extent by fabricating multilayer thermal conductive sheets through spraying liquid metal on the surface of an indium layer. However, the structure is typically complicated, and the provision of multilayer structure increases thermal contact resistance, thereby failing to effectively improve the overall thermal conductivity of the product.

### SUMMARY

In view of the deficiencies in the prior art, the embodiments of the present disclosure are directed to providing a multilayer composite thermal conductive sheet, and a preparation method therefor and an application thereof, which can address problems such as leakage, void formation, and sagging caused by phase transition of liquid metal, while simultaneously enhancing the thermal conductivity of the thermal conductive sheet.

According to a first aspect, an embodiment of the present disclosure provides a multilayer composite thermal conductive sheet including a metal foil, two transition layers respectively provided on opposite side surfaces of the metal foil, and two low-temperature alloy layers respectively provided on surfaces of the transition layers away from the metal foil. The metal foil is made of at least one material selected from silver, copper, zinc, and platinum. The transition layers are made of either indium or tin, and the thickness of the transition layers is in a range of 5-13 µm. According to the GB/T 9286-1998 test standard, the adhesion grade of the transition layers to the surface of the metal foil is grade 0, which represents the highest level. The melting point of the low-temperature alloy layer is in a range of 30-300°C.

In the present disclosure, a metal foil serves as a central base layer, transition layers are provided on a surface of the metal foil, and a low-temperature alloy layer is provided on a surface of the transition layers. When the low-temperature alloy layer undergoes phase transition and melts, the transition layers can react with the liquid metal to quickly form an alloy, thereby effectively solving the problems such as leakage, sagging, and void formation of the liquid metal. Moreover, by controlling the composition, maintaining a relatively small thickness, and achieving the highest adhesion grade, the transition layer can stably bond the metal foil and the low-temperature alloy layer. This can improve the adhesion between the transition layer and the metal foil, and the adhesion between the transition layer and the low-temperature alloy layer, which can reduce the thermal contact resistance between different material layers, thereby ensuring the structural integrity and stability of the overall sheet. The simple structural combination of the metal foil, transition layer, and low-temperature alloy layer provides the multilayer composite thermal conductive sheet with excellent thermal performance, with a thermal conductivity of not less than 25 W/m·K and a thermal resistance of not exceeding 0.025 cm²·K/W.

In some embodiments of the present disclosure, the low-temperature alloy layers include the following components in parts by mass: 45-70 parts of In, 20-40 parts of Bi, 5-20 parts of Sn, and 0-15 parts of Ga. More preferably, a material of the low-temperature alloy layers is a quaternary alloy of In₅₁Bi_{30.5}Sn_{15.5}Ga₃.

In some embodiments of the present disclosure, the thickness of the transition layers is in a range of 6-8 µm.

In some embodiments of the present disclosure, the thickness of the metal foil is in a range of 0.01-0.5 mm.

In some embodiments of the present disclosure, the thickness of the low-temperature alloy layers is in a range of 5-40 µm.

According to a second aspect, an embodiment of the present disclosure provides a preparation method for the above-mentioned multilayer composite thermal conductive sheet, including the following steps:
forming transition layers on opposite surfaces of a metal foil; and
spraying liquid metal on surfaces of the transition layers away from the metal foil to form low-temperature alloy layers.

In some embodiments of the present disclosure, the step of "forming transition layers on opposite surfaces of a metal foil" specifically includes:
forming transition layers on opposite surfaces of a metal foil by electroplating or magnetron sputtering.

Employing electroplating or magnetron sputtering can further improve the adhesion of the transition layer to the surface of the metal foil, thus ensuring a stable connection and producing a dense and uniform transition layer, thereby effectively reducing the interfacial thermal resistance between the transition layer and the metal foil.

In some embodiments of the present disclosure, the electroplating step specifically includes:
immersing a metal foil in an electroplating solution to electroplate to form the transition layers on the surface of the metal foil, wherein the electroplating solution includes anionic surfactants and non-ionic surfactants.

According to a third aspect, the present disclosure further provides an application of the above-mentioned multilayer composite thermal conductive sheet, for example, it can be used for heat dissipation of electronic components.

### BRIEF DESCRIPTION OF DRAWINGS

In order to more explicitly illustrate the technical solution of the embodiments of the present disclosure, the drawings required for the embodiments are briefly described below. It should be understood that the following drawings only show some embodiments of the present disclosure and should not be construed as limiting the scope of the present disclosure. A person of ordinary skill in the art can derive other related drawings based on these drawings without the exercise of inventive efforts.
FIG. 1 is a schematic diagram of a structure of a multilayer composite thermal conductive sheet of the present disclosure.
FIG. 2 is a state diagram of a multilayer composite thermal conductive sheet according to Example 1 of the present disclosure after thermal resistance testing.
FIG. 3 is a state diagram of a multilayer composite thermal conductive sheet according to Example 1 of the present disclosure after a 500-hour sagging test at 125 °C.
FIG. 4 is a state diagram of a multilayer composite thermal conductive sheet according to Example 1 of the present disclosure after a 1000-hour sagging test at 125°C.
FIG. 5 is a diagram showing adhesion test results of Example 1 of the present disclosure.
FIG. 6 is a diagram showing adhesion test results of Comparative Example 4 of the present disclosure.

Numerical references: 10-metal foil; 20-transition layer; 30-low-temperature alloy layer; 100-multilayer composite thermal conductive sheet.

### DETAILED DESCRIPTION OF EMBODIMENTS

In order to make the objectives, technical solutions, and advantages of the present disclosure more apparent, the technical solutions of the embodiments of the present disclosure are described in detail below in an explicit and complete manner. Unless otherwise specified, conditions not explicitly stated in the embodiments shall be understood as conventional conditions or conditions recommended by manufacturers. Reagents or instruments not specifically identified by the manufacturer are all commercially available conventional products.

The following is a specific description of a multilayer composite thermal conductive sheet, and a preparation method therefor and an application thereof according to an embodiment of the present disclosure.

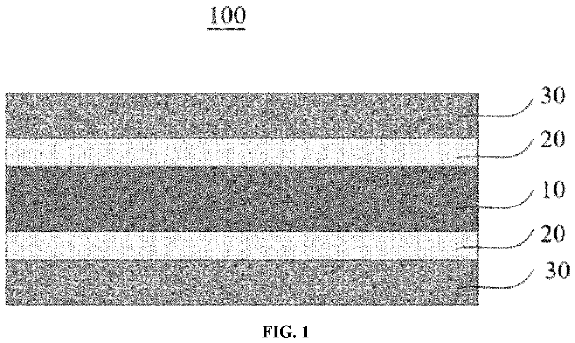

Referring to FIG. 1, an embodiment of the present disclosure provides a multilayer composite thermal conductive sheet 100, including a metal foil 10, two transition layers 20 provided on opposite side surfaces of the metal foil 10, and two low-temperature alloy layers 30 provided on surfaces of the transition layers 20 away from the metal foil 10. The metal foil 10 is made of at least one material selected from silver, copper, zinc, and platinum; the transition layer 20 is made of either indium or tin; and the thickness of the transition layer 20 is in a range of 5-13 µm. According to the GB/T 9286-1998 test standard, the adhesion grade of the transition layer to the surface of the metal foil is grade 0. The melting point of the low-temperature alloy layer 30 is in a range of 30-300°C.

Those skilled in the art understand that in a multilayer composite structure, interfacial thermal resistance difference exists between different layers of different materials due to differences in thermal conductivity and in phonon transmission rates. Therefore, the more layers there are, the worse the thermal resistance performance will be. In the present disclosure, the multilayer composite thermal conductive sheet 100 is a simple five-layer structure including three types of materials: a metal foil 10, a transition layer 20, and a low-temperature alloy layer 30. The metal foil 10, serving as the central base layer, not only has excellent thermal conductivity, but also has high strength and flexibility, thereby functioning both as a product skeleton and a high-thermal conductive layer. The transition layer 20, made of indium or tin, is connected to the metal foil 10 and the low-temperature alloy layer 30. The transition layer 20 can bond with the liquid metal melted on the surface and quickly absorb the liquid metal on the surface of the metal foil, effectively preventing leakage. By ensuring the transition layer 20 to be the highest adhesion grade and a relatively small thickness, it can closely attach to the surface of the metal foil 10 on the basis of fully absorbing the liquid metal on the surface, thereby reducing the thermal contact resistance between different materials and preventing delamination or detachment between layers, thus ensuring the stability of the overall structure.

In the present disclosure, the melting point of the low-temperature alloy layer 30 is in a range of 30-300°C and remains solid at room temperature. When heated (such as to 50-70°C), it undergoes a phase transition and melts, partially filling gaps at the thermal interface, such as micro-undulations and gaps between a chip and a heat dissipation module, thereby achieving ultra-low thermal resistance and functioning as a "thermal interface material". Meanwhile, the other part can quickly react and fuse with the transition layer 20 to form a new alloy, thereby preventing leakage.

In the present disclosure, the cooperation among the metal foil, transition layer, and low-temperature alloy layer ensures the integrity and stability of the multilayer composite thermal conductive sheet. During the normal operation of the device to be cooled, the entire thermal conductive sheet remains in a solid state (without any liquid phase), effectively overcoming critical defects such as liquid metal flow and sagging, and effectively improving the overall thermal performance of the structure. The thermal conductivity of the multilayer composite thermal conductive sheet is not less than 25 W/m·K, and the thermal resistance does not exceed 0.025 cm²·K/W. Under preferred conditions, the thermal conductivity of the multilayer composite thermal conductive sheet 100 can be as high as 32.5 W/m·K, and the thermal resistance can be as low as 0.007 cm²·K/W.

It is understood that the low-temperature alloy in the present disclosure refers to a low-melting-point alloy, preferably with a melting point in a range of 30-130°C, and typically composed of low-melting-point metal elements such as In, Bi, and Sn. In some embodiments, the low-temperature alloy layer includes the following components in parts by mass: 50-70 parts of In, 20-40 parts of Bi, 5-20 parts of Sn, and 0-15 parts of Ga, and specifically examples include quaternary alloys such as In₅₁Bi_{30.5}Sn_{15.5}Ga₃, In₆₃Bi₂₀Sn₁₀Ga₇, and In₄₉Bi₂₈Sn₁₁Gai₂.

Preferably, the low-temperature alloy layer is made of the quaternary alloy In₅₁Bi_{30.5}Sn_{15.5}Ga₃, and the transition layer is made of indium, allowing for strong bonding between the low-temperature alloy layer and the indium layer.

The more parts by mass of gallium are, the greater its corrosiveness is, the lower the melting point of the resulting liquid alloy is, the higher its fluidity is, and the worse the stability of the prepared multilayer composite thermal conductive sheet is.

In some embodiments, a thickness of the metal foil is in a range of 0.01-0.5 mm. The metal foil has high thermal conductivity (for example, the thermal conductivity of copper sheet can reach up to 400 W/m·K) and high strength. A thinner metal foil generally results in lower thermal resistance. However, if the metal foil is too thin, residual internal stress may exist, potentially causing surface unevenness (for example, copper has a relatively poor plasticity).

In some embodiments, the thickness of the transition layer can be in a range of 6-8 µm, specifically such as 6 µm, 6.3 µm, 6.2 µm, and 5.5 µm. The thermal conductivity of the transition layer is lower than that of the metal foil, for example, the thermal conductivity of an indium sheet is only 80 W/m·K. If the transition layer is too thin, it will not completely absorb the liquid metal on the surface of the metal foil. If the transition layer is too thick, it will affect the thermal performance. In addition, the adhesion strength and uniformity of the transition layer on the metal foil will also influence the thermal stability and thermal contact resistance of the overall thermal conductive sheet.

In some embodiments, the thickness of the low-temperature alloy layer is in a range of 5-40 µm, and specifically such as 20 µm, 40 µm, and 5 µm. The low-temperature alloy layer is required to both fill gaps and fuse with the transition layer to form a high-melting-point alloy, thereby ensuring that the molten low-temperature alloy does not overflow and leak. Therefore, if the low-temperature alloy layer is too thick, excessive molten liquid metal may overflow and leak, and if it is too thin, the gap-filling effect may be poor, resulting in poor thermal conductivity.

Correspondingly, the present disclosure further provides a preparation method for the above-mentioned multilayer composite thermal conductive sheet, including the following steps:
forming transition layers on opposite surfaces of a metal foil; and
spraying liquid metal on surfaces of the transition layers away from the metal foil to form low-temperature alloy layers.

In the method, the transition layers are formed on the opposite surfaces of the metal foil by electroplating or magnetron sputtering.

By adopting electroplating or magnetron sputtering instead of rolling or coating methods to form the transition layer, the transition layer can be densely and uniformly distributed on the surface of the metal foil. This ensures that even at an extremely small thickness, the adhesion grade can reach grade 0, thereby reducing the thermal contact resistance of the interfaces between different materials and ensuring the stability of the overall structure. Since the surface of the metal foil often has an oxide film, conventional rolling or coating methods may fail to achieve good bonding between the transition layer and the metal foil, resulting in a high thermal contact resistance between the two. In addition, low-melting-point liquid metal alloys belong to intermetallic compounds with higher hardness than pure metals and greater brittleness. If the adhesion is insufficient, the transition layer will be detached from the metal foil surface by the liquid metal under its unmelted state.

Specifically, the electroplating method includes the following steps:
immersing the metal foil in an electroplating solution, and applying electric current for a period of time to electroplate to form the transition layers on the opposite surfaces of the metal foil. The electroplating solution includes anionic surfactants and non-ionic surfactants. The anionic surfactant can be sodium dodecyl sulfate, and the non-ionic surfactant can be alkoxy polyethylene glycol hydroxyethyl alcohol. The anionic surfactants and non-ionic surfactants can enhance the adhesion, uniformity, and purity of a coated layer on a layer to be coated.

It is understood that the electroplating solution further includes indium ions or tin ions, such as indium sulfate or tin sulfate. In some embodiments, the electroplating solution further includes sodium hydroxide for pH adjustment.

In addition, the present disclosure further provides applications of the above-mentioned multilayer composite thermal conductive sheet, for example, it is used for heat dissipation of electronic components. The electronic component may exemplarily but not limitedly include a chip or a heat sink.

The features and performance of the present disclosure are further described in detail below in conjunction with examples.

### Example 1

This example provided a multilayer composite thermal conductive sheet. The metal foil was a copper sheet, the transition layer was an indium layer, and the low-temperature alloy layer was a quaternary alloy of In₅₁Bi_{30.5}Sn_{15.5}Ga₃. The multilayer composite thermal conductive sheet was prepared by the following method.
(1) The copper foil was rolled to produce a metal foil with a thickness of 0.05 mm;
(2) The above metal foil was placed in an electroplating solution for electrodeposition of indium, wherein it was applied a current at a density of 1 A/m² for two hours, and then dried, so as to form transition layers on the opposite side surfaces of the metal foil. The electroplating solution included dilute sulfuric acid, indium sulfate, sodium dodecyl sulfate, alkoxy polyethylene glycol hydroxyethyl alcohol, and sodium hydroxide.
(3) The 4N pure indium particles, bismuth particles, tin particles, and gallium particles were taken as raw materials of the low-temperature alloy layer, wherein a mass ratio the indium particles, bismuth particles, the tin particles, and the gallium particles in was 51:30.5:15.5:3. The raw materials weighed in proportion and placed into a vacuum medium frequency melting furnace, wherein it was vacuumized and heated to 400°C for two hours, and then taken out. It was put into a vacuum heating stirrer, wherein it was stirred with a temperature of 80°C and at a speed of 400 rad/min for 30 minutes, so that the liquid metal was mixed uniformly to obtain a quaternary alloy of In₅₁Bi_{30.5}Sn_{15.5}Ga₃ with a melting point of 55-60°C.
(4) The uniformly mixed liquid metal was poured into a mechanical pump to be heated, wherein the mechanical pump was connected to a heating tube, and the heating tube was connected to a heating spray head. The overall temperature was maintained at 120°C. The mechanical pump was powered on to pump the liquid metal into a spray tube for spraying, wherein the liquid metal was sprayed to a required area by arranging a moving direction of a spray head, and a servo motor was adjusted to control the spray speed to be 200 mm/c. A heat dissipation module to be sprayed was placed below the spray head, wherein the spray head was 30 cm away from a spray surface. The liquid metal mist was sprayed on a surface of the transition layer to form the low-temperature alloy layer with a thickness of 20 µm, then it was cooled and molded, so as to obtain a multilayer composite thermal conductive sheet.

### Example 2

This example was substantially the same as the preparation method of Example 1, except that:
in step (1), the thickness of the metal foil was 0.1 mm.

### Example 3

This example was substantially the same as the preparation method of Example 1, except that:
in step (1), the thickness of the metal foil was 0.2 mm.

### Example 4

This example was substantially the same as the preparation method of Example 1, except that:
in step (1), the thickness of the metal foil was 0.01 mm.

### Example 5

This example was substantially the same as the preparation method of Example 1, except that:
in step (3), 4N pure indium particles, bismuth particles, tin particles, and gallium particles were taken as raw materials in the liquid metal with a mass ratio of 63:20:10:7, so as to obtain a quaternary alloy of In₆₃Bi₂₀Sn₁₀Ga₇ with a melting point of 45-50°C.

### Example 6

This example was substantially the same as the preparation method of Example 1, except that:
in step (3), 4N pure indium particles, bismuth particles, tin particles, and gallium particles were taken as raw materials in the liquid metal with a mass ratio of 49:28:11:12, so as to obtain a quaternary alloy of In₄₉Bi₂₈Sn₁₁Ga₁₂ with a melting point of 40-45°C.

### Example 7

This example was substantially the same as the preparation method of Example 1, except that:
in step (4), the thickness of the sprayed low-temperature alloy layer was 5 µm.

### Example 8

This example was substantially the same as the preparation method of Example 1, except that:
in step (4), the thickness of the sprayed low-temperature alloy layer was 40 µm.

### Example 9

This example was substantially the same as the preparation method of Example 1, except that:
in step (2), the electric current was applied for four hours.

### Comparative Example 1

This comparative example was substantially the same as the preparation method of Example 1, except that:
in step (2), the electric current was applied for five hours.

### Comparative Example 2

This comparative example was substantially the same as the preparation method of Example 1, except that:
in step (2), the electric current was applied for 0.5 hours.

### Comparative Example 3

This comparative example was substantially the same as the preparation method of Example 1, except that:
in step (2), an indium sheet was rolled onto the metal foil to obtain a transition layer with a thickness of 6 µm.

### Comparative Example 4

This comparative example was substantially the same as the preparation method of Example 1, except that:
in step (2), a layer of molten indium was coated on a surface of the metal foil, and it was dried to obtain an indium layer with a thickness of 6 µm.

Performance testing was performed on the multilayer composite thermal conductive sheet prepared in Examples 1-9 and Comparative Examples 1-4, and each performance testing method was as follows.
(1) Thermal conductivity/thermal resistance: the test was performed with a thermal coefficient tester (model Longwin 9389) from Taiwan Long Win Science & Technology Corporation, and the test parameters were 50 psi, 80°C, and 20min.
(2) Sagging: the multilayer composite thermal conductive sheet was vertically placed in an oven at 125°C for 500 hours and 1000 hours.
(3) Adhesion force: after the transition layer was formed on the metal foil, it selected samples to test the adhesion force of the transition layer on the metal foil in accordance with the GBT 9286-1998 test standard. The adhesion force was classified into six grades from 0 to 5 according to the test results, and the evaluation criterion corresponding to each grade was as follows.

Grade 0: a cutting edge was completely smooth, and no square was detached off.
Grade 1: slight coating detachment was observed at a cut intersection, but an affected cross-cut area was not significantly greater than 5%
Grade 2: coating detachment was observed at the cut intersection and/or along the cutting edge; and the affected cross-cut area was significantly greater than 5%, but not significantly greater than 15%.
Grade 3: the coating was detached off partially or completely along the cutting edge in large fragments, and/or a square was partially or completely detached off at different parts; and the affected cross-cut area was significantly greater than 15%, but not significantly greater than 35%.
Grade 4: the coating was detached off along the cutting edge in large fragments, and/or some squares were partially or completely detached off; and the affected cross-cut area was significantly greater than 35%, but not significantly greater than 65%.
Grade 5: the degree of peeling exceeded that of the grade 4.

The results of the above performance test are shown in Table 1.

**Table 1 Thickness of Transition Layer and Performance of Corresponding Multilayer Composite Thermal Conductive Sheet in Examples and Comparative Examples**

| Group | Thermal conductivity (W/m·K) | Thermal resistance (cm²·K/W) | Thickness of transition layer (µm) | Adhesion force grade |
|---|---|---|---|---|
| Example 1 | 32.5 | 0.007 | 6 | 0 |
| Example 2 | 29.4 | 0.017 | 6.3 | 0 |
| Example 3 | 28.8 | 0.021 | 6.2 | 0 |
| Example 4 | 27.5 | 0.012 | 5.5 | 0 |
| Example 5 | 26.8 | 0.022 | 6 | 0 |
| Example 6 | 29 | 0.018 | 6.2 | 0 |
| Example 7 | 26 | 0.024 | 6.2 | 0 |
| Example 8 | 29.5 | 0.017 | 6 | 0 |
| Example 9 | 25 | 0.025 | 12 | 0 |
| Comparative Example 1 | 21.2 | 0.041 | 20 | 1 |
| Comparative Example 2 | 22.7 | 0.033 | 2 | 1 |
| Comparative Example 3 | 18 | 0.06 | 6 | 4 |
| Comparative Example 4 | 19.2 | 0.057 | 6 | 3 |

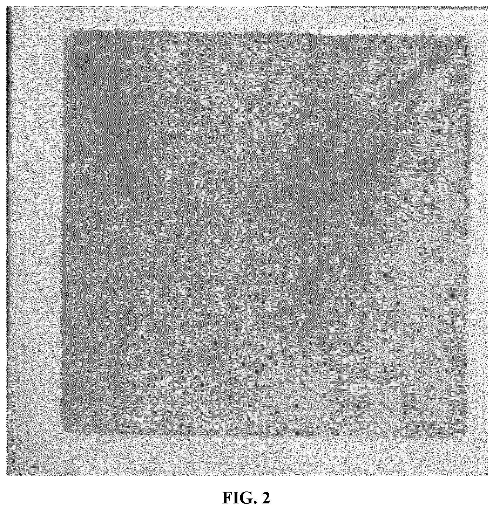

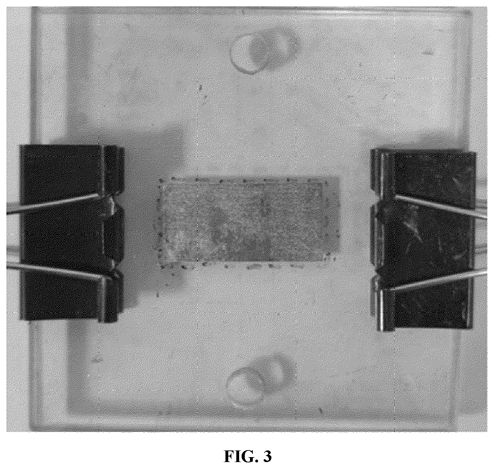

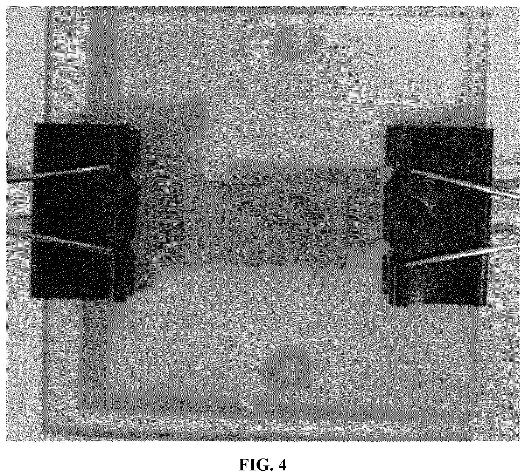

By comparing the performance test results in Table 1, it can be seen that the thermal conductivity of the multilayer composite thermal conductive sheets prepared in Examples 1-9 is not less than 25 W/m·K, and the thermal resistance does not exceed 0.025 cm²·K/W. In conjunction with the test results of FIG. 2, FIG. 3, and FIG. 4, it can be seen that there is no sagging, deformation, or overflow of products. From the comparison of the test results of Comparative Examples 1-2 and Example 1, it can be seen that the transition layer is too thick or too thin can affect the thermal conductivity of the final thermal conductive sheet, and the adhesion force grade will also be reduced.

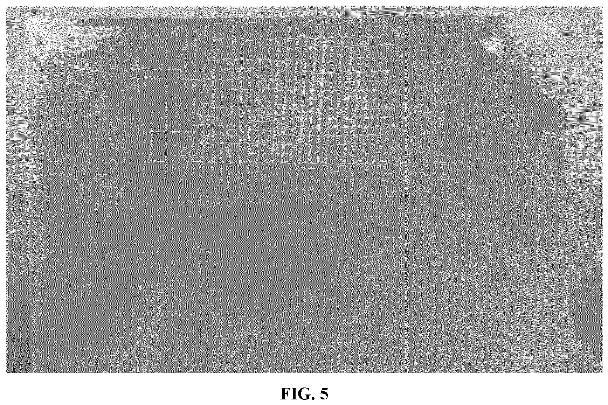

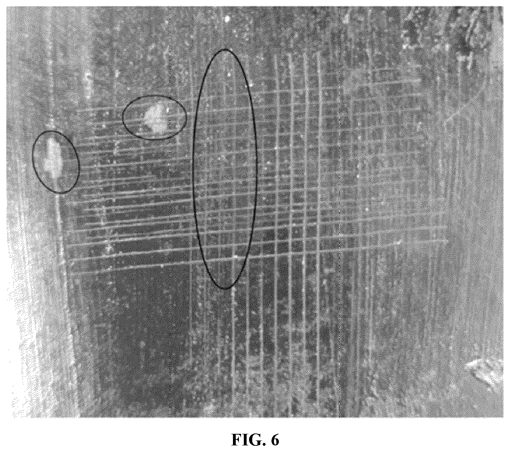

By comparing the test results of Comparative Examples 3-4 and Example 1, it can be seen that the transition layer is formed by electroplating in Example 1. From the adhesion test results in FIG. 5, it can be seen that the cut surface of the transition layer is smooth, and after tearing off the adhesive tape, no square detaches off. The adhesion force grade is grade 0, and the corresponding thermal conductivity is as high as 32.5 W/m·K, and the thermal resistance is as low as 0.007 cm²·K/W. However, the transition layer formed by pressing or coating in Comparative Examples 3-4 has poor uniformity, and the adhesion force of the transition layer on the surface of the metal foil is significantly reduced. From the state diagram of Comparative Example 4 after the adhesion test in FIG. 6, it can be seen that the circled area in the figure has detached off. In addition, insufficient adhesion may cause an oxide layer to form on the surface of the metal foil, thereby affecting the thermal conductivity path (the thermal conductivity of the oxide layer is ten or dozens of times worse than that of the pure metal). Therefore, the thermal conductivity of the overall thermal conductive sheet can be reduced.

The above-described embodiments are a part but not all of the embodiments of the present disclosure. The detailed description of the embodiments of the present disclosure is not intended to limit the scope of the scope of the present disclosure, but merely represents selected embodiments of the present disclosure. All other embodiments, derived by those of ordinary skill in the art based on the embodiments of the present disclosure without the exercise of inventive efforts, are all intended to be included within the scope of the protection of the present disclosure.

## Claims

1. A multilayer composite thermal conductive sheet (100), comprising: a metal foil (10), two transition layers (20) respectively provided on opposite side surfaces of the metal foil (10), and two low-temperature alloy layers (30) respectively provided on surfaces of the transition layers (20) away from the metal foil (10), **characterized in that**
the metal foil (10) is made of at least one material selected from silver, copper, zinc, and platinum;
the transition layers (20) are made of either indium or tin; a thickness of the transition layers (20) is in a range of 5-13 µm; according to the GB/T 9286-1998 test standard, an adhesion grade of the transition layers (20) to the surface of the metal foil (10) is grade 0; and
a melting point of the low-temperature alloy layers (30) is in a range of 30-300°C.

2. The multilayer composite thermal conductive sheet (100) according to claim 1, wherein the low-temperature alloy layers (30) comprise the following components in parts by mass: 45-70 parts of In, 20-40 parts of Bi, 5-20 parts of Sn, and 0-15 parts of Ga.

3. The multilayer composite thermal conductive sheet (100) according to claim 2, wherein a material of the low-temperature alloy layers (30) is a quaternary alloy of In₅₁Bi_{30.5}Sn_{15.5}Ga₃.

4. The multilayer composite thermal conductive sheet (100) according to claim 1, wherein the thickness of the transition layers (20) is in a range of 6-8 µm.

5. The multilayer composite thermal conductive sheet (100) according to claim 1, wherein a thickness of the metal foil (10) is in a range of 0.01-0.5 mm.

6. The multilayer composite thermal conductive sheet (100) according to claim 1, wherein a thickness of the low-temperature alloy layers (30) is in a range of 5-40 µm.

7. A preparation method for the multilayer composite thermal conductive sheet (100) according to any one of claims 1 to 6, **characterized by** comprising the following steps:
forming the transition layers (20) on the opposite surfaces of the metal foil (10); and
spraying liquid metal on the surfaces of the transition layers (20) away from the metal foil (10) to form the low-temperature alloy layers (30).

8. The preparation method according to claim 7, wherein a step of "forming the transition layers (20) on the opposite surfaces of the metal foil (10)" comprises:
forming the transition layers (20) on opposite surfaces of the metal foil (10) by electroplating or magnetron sputtering.

9. The preparation method according to claim 8, wherein the step of electroplating comprises:
immersing the metal foil (10) in an electroplating solution to electroplate to form the transition layers (20) on the opposite surfaces of the metal foil (10), wherein the electroplating solution comprises anionic surfactants and non-ionic surfactants.

10. An application of the multilayer composite thermal conductive sheet (100) according to any one of claims 1 to 6, **characterized in that** the multilayer composite thermal conductive sheet (100) is used for heat dissipation of electronic components.
